# EUROPÄISCHE PATENTSCHRIFT

(11) **EP 1 153 460 B1**
(45) Veröffentlichungstag und Bekanntmachung des Hinweises auf die Patenterteilung: **18.01.2006**
(21) Anmeldenummer: 00979442.1
(22) Anmeldetag: 20.10.2000
(51) Int. Cl.: H01R 3/00

(54) **VORRICHTUNG ZUR ELEKTRISCHEN UND MECHANISCHEN VERBINDUNG VON ZWEI LEITERPLATTEN**
DEVICE FOR ELECTRICALLY AND MECHANICALLY CONNECTING TWO PRINTED CIRCUIT BOARDS
DISPOSITIF POUR ASSEMBLER ELECTRIQUEMENT ET MECANIQUEMENT DEUX PLAQUETTES A CIRCUIT IMPRIME

(30) Priorität: 21.10.1999 DE 19950757
(43) Veröffentlichungstag der Anmeldung: 14.11.2001
(73) Patentinhaber: ROBERT BOSCH GMBH, 70442 Stuttgart (DE)
(72) Erfinder: ZEIN, Walter, 72555 Metzingen (DE); SCHMID, Ralf, 87662 Kaltental (DE); FREY, Martin, 72805 Lichtenstein (DE)
(86) Internationale Anmeldenummer: PCT/DE2000/003697
(87) Internationale Veröffentlichungsnummer: WO 2001/029928

(56) Entgegenhaltungen:
- US-A- 2 938 068
- US-A- 3 857 994
- US-A- 5 410 807
- US-A- 5 529 504

## Beschreibung

### Stand der Technik

Die Erfindung betrifft eine Vorrichtung zur elektrischen und mechanischen Verbindung von zwei Leiterplatten mit den im Oberbegriff des unabhängigen Anspruchs 1 angegebenen Merkmalen.

Eine derartige Vorrichtung ist beispielsweise aus dem Artikel "Leiterplatten flexibel verbinden" in Feinwerktechnik & Meßtechnik 1991, Seiten 204-205 bekannt und umfaßt elektrisch leitende Kontaktstifte, die mit den Leiterbahnen einer starren Leiterplatte elektrisch verbunden sind. Die Kontaktstifte stehen senkrecht von der starren Leiterplatte ab und werden gegebenenfalls noch durch einen Kunststoffträger stabilisiert. Das von der starren Leiterplatte abstehende Ende der Kontaktstifte ist durch je eine Öffnung einer elastisch biegsamen Folienleiterplatte hindurchgeführt und auf der Rückseite der Folienleiterplatte mit den dort vorhandenen Leiterbahnen verlötet. Andere Vorrichtungen umfassen Anpreßverbinder oder Steckverbinder. Nachteilig bei den bekannten Vorrichtungen ist die umständliche Montage und der große Aufwand bei der Herstellung der Kontaktierungsmittel, durch welchen die Kosten stark erhöht werden. Insbesondere das Verlöten der Kontaktstifte mit den Leiterbahnen der elastisch biegsamen Folienleiterplatte macht einen zusätzlichen Lötprozeß erforderlich. Bei mechanischen Belastungen der Lötverbindungen, die beispielsweise aus Vibrations- oder Zugbelastungen der Folienleiterplatte resultieren, können die Lötverbindungen schnell beschädigt werden, so daß derartige Verbindungen nicht sehr zuverlässig sind.

### Vorteile der Erfindung

Mit der erfindungsgemäßen Vorrichtung nach dem Anspruch 1 der Anmeldung werden die im Stand der Technik bekannten Nachteile vermieden und eine preiswerte und zuverlässige Verbindung von zwei Leiterplatten ermöglicht. Vorteilhaft besteht die Vorrichtung aus zwei einfach zu fertigenden Teilen. Eine erhebliche Montageerleichterung resultiert daraus, daß eine erste, vorzugsweise elastisch biegsame Leiterplatte durch Verwendung des Klemmteils und des damit zusammenwirkenden Kontaktstiftes mit wenigen Handgriffen sicher an einer zweiten Leiterplatte befestigt werden kann. Die Vorrichtung ist sehr robust und zuverlässig und bildet bei Vibrations- und Schüttelbelastungen der ersten Leiterplatte bedingt durch die elastische Biegsamkeit des Klemmteils vorteilhaft eine Zugentlastung für die zweite Leiterplatte. Das Klemmteil und der Kontaktstift sind mit einfachen Techniken preisgünstig herstellbar.

Weiterentwicklungen der Erfindung und vorteilhafte Ausführungen werden durch die in den Unteransprüchen angegebenen Merkmale ermöglicht.

Eine besonders zuverlässige Festlegung des Klemmteils an dem Kontaktstift wird dadurch erreicht, daß das Klemmteil eine Ausnehmung zur Durchführung des Kontaktstiftes aufweist, von deren Innenrand aus sich krallenartig ausgebildete Vorsprünge zum Kontaktstift hin erstrecken und diesen allseitig umklammern.

Weiterhin ist vorteilhaft, daß die Ausnehmung von einem ringförmig ausgebildeten Abschnitt des Klemmteils umgeben ist, welcher Abschnitt an seinem von der Ausnehmung abgewandten Außenrand zur Ausnehmung hin derart zurückgebogen ist, daß die Unterseite des zurückgebogenen Abschitts einen ringförmigen Auflagebereich des Klemmteils zur Auflage auf der ersten Leiterplatte ausbildet. Durch die Biegung ist der Auflagebereich gegen den ringförmig ausgebildeten Bereich beweglich und legt sich immer flach an die Leiterbahn der ersten Leiterplatte an.

Besonders vorteilhaft ist, daß das Klemmteil eine umlaufende Nut aufweist und daß das Klemmteil derart in der Öffnung der ersten Leiterplatte festlegbar ist, daß der Innenrand der Öffnung in die umlaufende Nut eingreift. Hierdurch kann das Klemmteil an der ersten Leiterplatte vormontiert werden, was die Montage erheblich erleichtert. Die erste Leiterplatte kann in der umlaufenden Nut festgeklemmt werden, so daß das Klemmteil zuverlässig mit einer die Öffnung umgebenden Leiterbahn der ersten Leiterplatte elektrisch verbunden ist.

Vorteilhaft ist weiterhin, daß der zur Ausnehmung hin zurückgebogene Abschnitt erneut derart zurückgebogen ist, daß ein weiterer zurückgebogener Abschnitt sich in etwa parallel zu dem Auflagebereich des Klemmteils erstreckt, wobei der zur Ausnehmung hin zurückgebogene Abschnitt und der weitere zurückgebogene Abschnitt zugleich die Seitenwände der umlaufenden Nut bilden.

Vorteilhaft bildet die von der umlaufenden Nut abgewandte Seite des weiteren zurückgebogenen Abschnitts einen zweiten Auflagebereich des Klemmeteils zur Auflage auf der zweiten Leiterplatte aus.

Weiterhin ist vorteilhaft, wenn der Kontaktstift sich in axialer Richtung erstreckende seitliche Nuten zum Eingriff der elastisch biegsamen Vorsprünge des Klemmteils aufweist, die an ihrem von der zweiten Leiterplatte abgewandten Ende geschlossen ausgebildet sind. Die Nuten ermöglichen ein zuverlässiges Umklammern des Kontaktstifts, wobei die geschlossenen Enden der Nuten Rastkanten bilden, hinter denen die elastisch biegsamen Vorsprünge des Klemmteils widerhakenartig in die Nuten eingreifen. Ein versehentliches Ablösen oder Abspringen des Klemmteils wird so vorteilhaft vermieden.

Vorteilhaft wird durch die kraftschlüssige Anlage der elastisch biegsamen Vorsprünge an dem Kontaktstift eine Krafteinleitung auf den Auflagebereich bewirkt, so daß der Auflagebereich gegen die Leiterbahn der ersten Leiterplatte fest angedrückt wird.

Das Klemmteil kann vorteilhaft einstückig ausgebildet werden. In einem bevorzugten Ausführungsbeispiel ist das Klemmteil ein Stanzbiegeteil aus Metallblech.

Es ist aber auch denkbar, das Klemmteil als ein elastisch biegsames Kunststoffteil auszugestalten, welches mit einem elektrisch leitenden Überzug versehen ist.

### Zeichnungen

Ein Ausführungsbeispiel der Erfindung wird in der Zeichnungen dargestellt und in der nachfolgenden Beschreibung erläutert. Es zeigt
Fig. 1 einen Querschnitt durch die erfindungsgemäße Verrichtung mit zwei Leiterplatten,
Fig. 2 eine Draufsicht auf Fig. 1.

### Beschreibung des Ausführungsbeispiels

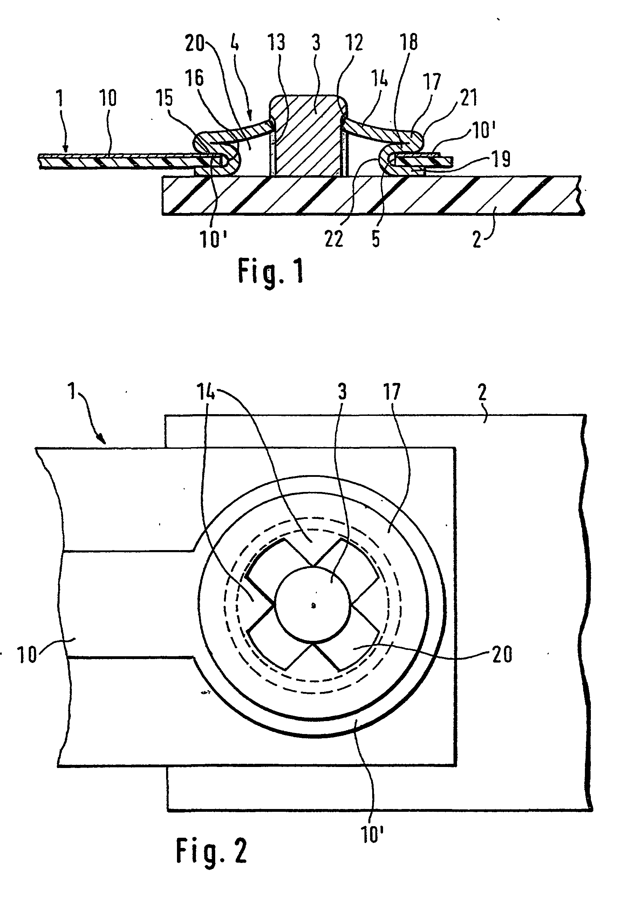

Fig. 1 zeigt die elektrische und mechanische Verbindung zweier Leiterplatten mittels der erfindungsgemäßen Vorrichtung. Dargestellt ist eine erste Leiterplatte 1 welche eine elastisch biegsame Leiterplatte, beispielsweise eine Folienleiterplatte sein kann. Derartige Folienleiterplatten bestehen beispielsweise aus einem Polyimid-Folienband, auf dem dünne Leiterbahnen 10 aus Kupfer aufgebracht sind, die mit einem Isolierstoffüberzug abgedeckt sind. Die Folienleiterplatte 1 weist kreisförmige Öffnungen 5 auf. Wie in Fig. 2 zu erkennen ist, umgeben Leiterbahnen 10 mit kreisringförmigen Endabschnitten 10' den Rand der Öffnung 5 auf der Oberseite der Folienleiterplatte 1. Über dem kreisringförmigen Abschnitt 10' der Leiterbahnen 10 ist die Isolierung entfernt, so daß dieser Abschnitt 10' von außen kontaktierbar ist. Eine zweite starre Leiterplatte 2 ist auf ihrer Oberseite mit einem elektrisch leitenden Kontaktstift 3 aus beispielsweise Metall versehen. Der Kontaktstift 3 ist mit einer nicht dargestellten Leiterbahn der zweiten Leiterplatte 2 elektrisch verbunden. Dies kann über Löten, Nieten, einen elektrisch leitenden Klebstoff oder in anderer Form geschehen. Der Kontaktstift 3 steht senkrecht von der Oberseite der Leiterplatte 2 ab und weist im wesentlichen eine zylinderförmige Gestalt auf. Der Durchmesser des Kontaktstiftes 3 ist kleiner ausgebildet als der Innendurchmesser der Öffnung 5 der ersten Leiterplatte 1. Die Mantelfläche des zylinderförmigen Kontaktstiftes 3 ist mit vier sich in axialer Richtung erstreckenden Nuten 13 versehen, wobei das von der zweiten Leiterplatte 2 abgewandte Ende der Nuten 13 geschlossen ausgebildet ist.

Weiterhin ist ein Klemmteil 4 vorgesehen, welches mit dem Kontaktstift 3 zusammenwirkt. Das Klemmteil 4 ist in diesem Ausführungsbeispiel als elastisch biegsames, einstückiges Stanzbiegeteil aus Metall gebildet. Es ist aber auch möglich das Klemmteil 4 beispielsweise als ein elastisch biegsames Kunststoffteil zu fertigen, das mit einem elektrisch leitfähigen Überzug beschichtet ist. Das Klemmteil 4 weist einen ringförmig ausgebildeten Abschnitt 17 auf, in dessen Mitte eine Ausnehmung 20 eingebracht ist. Wie in Fig. 2 dargestellt ist, stehen vom Innenrand der im wesentlichen kreisförmigen Ausnehmung 20 vier Vorsprünge 14 zur Mitte der Ausnehmung 20 hin ab. Die Vorsprünge 14 sind zackenartig mit zum Mittelpunkt der kreisförmigen Ausnehmung 20 hin abstehenden scharfkantigen Spitzen ausgebildet. In dem hier gezeigten Ausführungsbeispiel liegen sich die Vorsprünge am Innenrand der Ausnehmung 20 diametral gegenüber. Es sind aber auch andere Ausgestaltungen des Klemmteils 4 mit nur zwei oder drei oder mehr als vier Vorsprüngen 14 möglich, die sich nicht diametral gegenüberliegen. Wie weiterhin in Fig. 1 zu erkennen ist, ist der von der Ausnehmung 20 abgewandte Außenrand des ringförmig ausgebildeten Abschnitts 17 im Querschnitt um etwa 180° nach unten zurückgebogen, wobei sich an die Biegung 21 ein zur Ausnehmung 20 hin erstreckender Abschnitt 18 anschließt. Die Unterseite des kreisringförmigen Abschnitts 18 bildet einen Auflagebereich 15 zur Auflage an der ersten Leiterplatte 1 aus. Der zurückgebogene Abschnitt 18 ist an seinem der Ausnehmung 20 zugewandten Ende mit einer weiteren Biegung 22 versehen an die sich ein von der Ausnehmung 20 weggerichteter ringförmiger Abschnitt 19 anschließt. Im halben Querschnitt bilden die über die Biegungen 21,22 miteinander verbundenen kreisringförmigen Abschnitte 17,18,19 eine S-förmige Kontur aus. Durch die über die Biegung 22 miteinander verbundenen ringförmigen Abschnitte 18 und 19 wird weiterhin eine umlaufend Nut 16 gebildet, in welche der Rand der Öffnung 5 der Leiterplatte 1 eingreift. Um das Klemmteil 4 an der Leiterplatte 1 festzulegen kann entweder die Elastizität der Folienleiterpatte 1 ausgenutzt werden, oder aber es wird so verfahren, daß zunächst das Klemmteil 4 mit noch nicht abgebogenem Abschnitt 19 in die Öffnung 5 eingesetzt und anschließend der Abschnitt 19 um die Öffnung 5 flanschartig herumgebogen wird. Dies kann so erfolgen, daß der Auflagebereich 15 des Klemmteils 4 fest gegen das kreisringförmige Ende 10' der Leiterbahn 10 angepreßt wird, so daß das Klemmteil 4 mit der Leiterbahn 10 elektrisch leitend verbunden ist.

Zur Festlegung der ersten Leiterplatte 1 an der zweiten Leiterplatte 2 wird dann so verfahren, daß der Kontaktstift 3 der zweiten Leiterplatte zunächst durch die Öffnung 5 der ersten Leiterplatte 1 und anschließend durch die Ausnehmung 20 des Klemmteils 4 hindurchgeschoben wird. Dabei spreizen die elastisch biegsamen Vorsprünge 14 zunächst an dem von der zweiten Leiterplatte 2 abgewandten Ende des Kontaktstiftes zurück und greifen schließlich mit ihren spitzen Enden hinter den Rastkanten 12 der Nuten 13 widerhakenartig in die Nuten 13 ein, wobei der Kontaktstift 3 von den Vorsprüngen 14 allseitig umklammert wird. Über den Kontaktstift 3, die Vorsprünge 14 und den Auflagebereich 15 ist die zweite Leiterplatte 2 mit der ersten Leiterplatte 1 elektrisch kontaktiert.

Es ist vorteilhaft, die axiale Länge des Kontaktstiftes 3 und des Klemmteils 4 so zu bemessen, daß die Vorsprünge 14 erst hinter den Rastkanten 12 eingreifen können, nachdem der kreisringförmige Abschnitt 19 des Klemmteils 4 bereits auf der zweiten Leiterplatte 2 zur Anlage gelangt ist. Die Vorsprünge 14 müssen dann manuell in Richtung der zweiten Leiterplatte angedrückt werden, um hinter den Rastkanten 12 einzuhaken. Hierdurch kann erreicht werden, daß der Abschnitt 19 gegen die zweite Leiterplatte 2 und der Auflagebereich 15 gegen die Leiterbahn 10 der ersten Leiterplatte vorgespannt wird, da die unter Vorspannung an den Rastkanten 12 anliegenden Vorsprünge 14 dann eine Krafteinleitung auf den Auflagebereich 15 hin bewirken. In diesem Fall wirkt das Klemmteil 14 zugleich als Spannteil.

In einem anderen Ausführungsbeispiel kann auf die umlaufende Nut 16 auch verzichtet werden. Die erste Leiterplatte 1 liegt dann unmittelbar auf der zweiten Leiterplatte 2 auf. In diesem Fall ist es dann erforderlich, daß der Auflagebereich 15 des Klemmteils 4, wie oben beschrieben, durch die Spannkraft der elastisch biegsamen Vorsprünge 14 gegen die Leiterbahn 10 vorgespannt wird, da ansonsten kein zuverlässiger elektrischer Kontakt entsteht.

Die an dem Kontaktstift 3 ausgebildeten axialen Nuten 13 mit den Rastkanten 12 können auch entfallen, wenn die Spannkraft der Vorsprünge 14 ausreicht, um diese fest gegen den Köntaktstift 3 anzupressen. Ist der Kontaktstift 3 aus einem weicheren Material als das Klemmteil 4 gefertigt, können sich die Vorsprünge 14 mit ihren scharfkantigen Spitzen in den Kontaktstift einkrallen.

## Patentansprüche

1. Vorrichtung zur elektrischen und mechanischen Verbindung einer ersten, vorzugsweise elastisch biegsamen Leiterplatte (1) mit einer zweiten Leiterplatte (2), wobei ein von der zweiten Leiterplatte (2) abstehender und durch eine Öffnung (5) in der ersten Leiterplatte (1) ragender elektrisch leitender Kontaktstift (3) mit einer Leiterbahn (10) der ersten Leiterplatte (1) elektrisch leitend verbunden wird, **dadurch gekennzeichnet, daß** ein elektrisch leitendes Klemmteil (4) mit daran ausgebildeten elastisch biegsamen, den Kontaktstift (3) kraftschlüssig umklammernden Vorsprüngen (14) vorgesehen ist, wobei ein mit den Vorsprüngen (14) elektrisch verbundener Auflagebereich (15) des Klemmteils (4) gegen eine auf der ersten Leiterplatte (1) angeordnete Leiterbahn (10) unter Vorspannung angedrückt wird.

2. Vorrichtung nach Anspruch 1, **dadurch gekennzeichnet, daß** das Klemmteil (4) eine Ausnehmung (20) zur Durchführung des Kontaktstiftes (3) aufweist, von deren Innenrand aus sich krallenartig ausgebildete Vorsprünge (14) zum Kontaktstift (3) hin erstrecken und diesen allseitig umklammern.

3. Vorrichtung nach Anspruch 2, **dadurch gekennzeichnet, daß** die Ausnehmung (20) von einem ringförmig ausgebildeten Abschnitt (17) des Klemmteils (4) umgeben ist, welcher Abschnitt (17) an seinem von der Ausnehmung (20) abgewandten Außenrand zur Ausnehmung (20) hin derart zurückgebogen ist, daß die Unterseite des zurückgebogenen Abschitts (18) einen ringförmigen Auflagebereich (15) des Klemmteils (4) zur Auflage auf der ersten Leiterplatte (1) ausbildet.

4. Vorrichtung nach Anspruch 1, **dadurch gekennzeichnet, daß** das Klemmteil (4) eine umlaufende Nut (16) aufweist und daß das Klemmteil (4) derart in der Öffnung (5) der ersten Leiterplatte (1) festlegbar ist, daß der Innenrand der Öffnung (5) in die umlaufende Nut (16) eingreift.

5. Vorrichtung nach Anspruch 3 und 4, **dadurch gekennzeichnet, daß** der zur Ausnehmung (20) hin zurückgebogene Abschnitt (18) erneut derart zurückgebogen ist, daß ein weiterer zurückgebogener Abschnitt (19) sich in etwa parallel zu dem Auflagebereich (15) des Klemmteils (4) erstreckt, wobei der zur Ausnehmung (20) hin zurückgebogene Abschnitt (18) und der weitere zurückgebogene Abschnitt (19) zugleich die Seitenwände der Nut (16) bilden.

6. Vorrichtung nach Anspruch 5, **dadurch gekennzeichnet, daß** die von der Nut (16) abgewandte Seite des weiteren zurückgebogenen Abschnitts (19) einen zweiten Auflagebereich des Klemmeteils (4) zur Auflage auf der zweiten Leiterplatte (2) ausbildet.

7. Vorrichtung nach Anspruch 1, **dadurch gekennzeichnet, daß** an dem Kontaktstift (3) sich in axialer Richtung erstreckenden seitliche Nuten (13) zum Eingriff der elastisch biegsamen Vorsprünge (14) des Klemmteils (4) ausgebildet sind, die an ihrem von der zweiten Leiterplatte (2) abgewandten Ende geschlossen ausgebildet sind.

8. Vorrichtung nach Anspruch 7, **dadurch gekennzeichnet, daß** die geschlossenen Enden (12) der Nuten (13) Rastkanten bilden, hinter denen die elastisch biegsamen Vorsprünge (14) des Klemmteils (4) widerhakenartig in die Nuten (13) eingreifen.

9. Vorrichtung nach Anspruch 1, **dadurch gekennzeichnet, daß** die elastisch biegsamen Vorsprünge (14) durch die kraftschlüssige Anlage an dem Kontaktstift (3) eine Krafteinleitung auf den Auflagebereich (15) bewirken, so daß der Auflagebereich (15) gegen die Leiterbahn (10) der ersten Leiterplatte (1) angedrückt wird.

10. Vorrichtung nach einem der vorstehenden Ansprüche, **dadurch gekennzeichnet, daß** das Klemmteil (4) einstückig ausgebildet ist.

11. Vorrichtung nach Anspruch 10, **dadurch gekennzeichnet, daß** das Klemmteil (4) ein Stanzbiegeteil aus Metallblech ist.

12. Vorrichtung nach Anspruch 10, **dadurch gekennzeichnet, daß** das Klemmteil (4) ein elastisch biegsames Kunststoffteil ist, auf das ein elektrisch leitender Überzug aufgebracht ist.

## Claims

1. Apparatus for electrically and mechanically connecting a first, preferably elastically flexible printed circuit board (1) to a second printed circuit board (2), with an electrically conductive contact pin (3), which projects from the second printed circuit board (2) and protrudes through an opening (5) in the first printed circuit board (1), being electrically conductively connected to a conductor track (10) of the first printed circuit board (1), **characterized in that** an electrically conductive clamping part (4) is provided with elastically flexible projections (14) which are formed on said clamping part and non-positively clamp around the contact pin (3), with a bearing region (15), which is electrically connected to the projections (14), of the clamping part (4) being pressed with prestress against a conductor track (10) arranged on the first printed circuit board (1).

2. Apparatus according to Claim 1, **characterized in that** the clamping part (4) has a recess (20) for guiding the contact pin (3) through, claw-like projections (14) extending towards the contact pin (3) from the inner edge of this recess and clamping around the said contact pin on all sides.

3. Apparatus according to Claim 2, **characterized in that** the recess (20) is surrounded by an annular section (17) of the clamping part (4), which section (17) is bent back towards the recess (20) at its outer edge facing away from the recess (20) in such a way that the lower side of the bent-back section (18) forms an annular bearing region (15) of the clamping part (4) for bearing on the first printed circuit board (1).

4. Apparatus according to Claim 1, **characterized in that** the clamping part (4) has a circumferential groove (16), and **in that** the clamping part (4) can be fixed in the opening (5) in the first printed circuit board (1) in such a way that the inner edge of the opening (5) engages into the circumferential groove (16).

5. Apparatus according to Claims 3 and 4, **characterized in that** the section (18) which is bent back towards the recess (20) is again bent back in such a way that a further bent-back section (19) extends approximately parallel to the bearing region (15) of the clamping part (4), with the section (18) which is bent back towards the recess (20) and the further bent-back section (19) at the same time forming the side walls of the groove (16).

6. Apparatus according to Claim 5, **characterized in that** the side of the further bent-back section (19) facing away from the groove (16) forms a second bearing region of the clamping part (4) for bearing on the second printed circuit board (2).

7. Apparatus according to Claim 1, **characterized in that** lateral grooves (13), which extend in the axial direction, serve for engagement of the elastically flexible projections (14) of the clamping part (4), and are of closed design at their end facing away from the second printed circuit board (2) are formed on the contact pin (3).

8. Apparatus according to Claim 7, **characterized in that** the closed ends (12) of the grooves (13) form latching edges behind which the elastically flexible projections (14) of the clamping part (4) engage into the grooves (13) in the manner of barbs.

9. Apparatus according to Claim 1, **characterized in that** the elastically flexible projections (14) introduce force onto the bearing region (15) by bearing non-positively against the contact pin (3), so that the bearing region (15) is pressed against the conductor track (10) of the first printed circuit board (1).

10. Apparatus according to one of the preceding claims, **characterized in that** the clamping part (4) is of one-piece design.

11. Apparatus according to Claim 10, **characterized in that** the clamping part (4) is a stamped and bent part made from sheet metal.

12. Apparatus according to Claim 10, **characterized in that** the clamping part (4) is an elastically flexible plastic part to which an electrically conductive coating is applied.

## Revendications

1. Dispositif permettant de relier électriquement et mécaniquement une première plaquette de circuit imprimé (1) de préférence souple et élastique avec une deuxième plaquette de circuit imprimé (2), une broche de contact (3) conductrice d'électricité partant de la deuxième plaquette de circuit imprimé (2) et traversant une ouverture (5) pratiquée dans la première plaquette de circuit imprimé (1), étant branchée sur une piste de circuit imprimé (10) de la première plaquette de circuit imprimé (1),
**caractérisé par**
une pièce de serrage (4) conductrice d'électricité, dotée de saillies (14) souples et élastiques, enserrant par complémentarité de forces la broche de contact (3), une zone d'appui (15) de la pièce de serrage (4) reliée électriquement aux saillies (14) étant pressée sous précontrainte contre une piste de circuit imprimé (10) de la première plaquette de circuit imprimé (1).

2. Dispositif selon la revendication 1,
**caractérisé en ce que**
la pièce de serrage (4) présente un évidement (20) pour le passage de la broche de contact (3), dont le bord intérieur est muni de saillies (14) sous forme de griffes dirigées vers la broche de contact (3) et l'enserrant de tous les côtés.

3. Dispositif selon la revendication 2,
**caractérisé en ce que**
l'évidement (20) est entouré par une section annulaire (17) de la pièce de serrage (4), cette section (17) étant repliée, au niveau de son bord extérieur opposé à l'évidement (20), en direction de l'évidement (20), de telle sorte que la face inférieure de la section repliée (18) forme une zone d'appui annulaire (15) de la pièce de serrage (4) pour l'appui sur la première plaquette de circuit imprimé (1).

4. Dispositif selon la revendication 1,
**caractérisé en ce que**
la pièce de serrage (4) présente une rainure périphérique (16), et la pièce de serrage (4) peut être fixée dans l'ouverture (5) de la première plaquette de circuit imprimé (1) de telle sorte que le bord intérieur de l'ouverture (5) s'engage dans la rainure périphérique (16).

5. Dispositif selon les revendications 3 et 4,
**caractérisé en ce que**
la section repliée (18) en direction de l'évidement (20) est repliée de telle sorte qu'une autre section repliée (19) soit approximativement parallèle à la zone d'appui (15) de la pièce de serrage (4), la section (18) repliée en direction de l'évidement (20) et l'autre section repliée (19) formant aussi les parois latérales de la rainure (16).

6. Dispositif selon la revendication 5,
**caractérisé en ce que**
le côté de l'autre section repliée (19) opposé à la rainure (16) forme une deuxième zone d'appui de la pièce de serrage (4) pour l'appui sur la deuxième plaquette de circuit imprimé (2).

7. Dispositif selon la revendication 1,
**caractérisé en ce que**
des rainures latérales (13) s'étendant en direction axiale au niveau de la broche de contact (3) sont conçues pour l'engagement des saillies (14) souples et élastiques de la pièce de serrage (4), et sont configurées de façon fermée au niveau de leur extrémité opposée à la deuxième plaquette de circuit imprimé (2).

8. Dispositif selon la revendication 7,
**caractérisé en ce que**
les extrémités fermées (12) des rainures (13) forment des arêtes de blocage derrière lesquelles les saillies (14) souples et élastiques de la pièce de serrage (4) s'engagent dans les rainures (13) à la façon de crochets contraires.

9. Dispositif selon la revendication 1,
**caractérisé en ce que**
les saillies (14) souples et élastiques appliquent par complémentarité de forces contre la broche de contact (3), une force sur la zone d'appui (15), pour presser la zone d'appui (15) contre la piste de circuit imprimé (10) de la première plaquette de circuit imprimé (1).

10. Dispositif selon l'une des revendications précédentes,
**caractérisé en ce que**
la pièce de serrage (4) est d'une seule pièce.

11. Dispositif selon la revendication 10,
**caractérisé en ce que**
la pièce de serrage (4) est une pièce flexible emboutie en tôle.

12. Dispositif selon la revendication 10,
**caractérisé en ce que**
la pièce de serrage (4) est une pièce en matière plastique souple et élastique munie d'un revêtement conducteur d'électricité.
